# EUROPEAN PATENT APPLICATION

(11) **EP 2 474 856 A1**
(43) Date of publication of application: **11.07.2012**
(21) Application number: 10811931.4
(22) Date of filing: 26.08.2010
(51) Int. Cl.: G02F 1/13357, C09K 11/08, C09K 11/64, F21S 2/00, H01L 33/50, H01L 51/50, H05B 33/12

(54) **LIQUID CRYSTAL DISPLAY**

(30) Priority: 31.08.2009 JP 2009200444; 17.06.2010 JP 2010138523
(71) Applicant: Sharp Kabushiki Kaisha, Osaka-shi, Osaka 545-8522 (JP)
(72) Inventor: TAKAHASHI, Kohsei, Osaka-shi Osaka-545-8522 (JP); WATANABE, Masanori, Osaka-shi Osaka-545-8522 (JP); HANAMOTO, Tetsuya, Osaka-shi Osaka-545-8522 (JP); MASUDA, Masatsugu, Osaka-shi Osaka-545-8522 (JP); TERASHIMA, Kenji, Osaka-shi Osaka 534-0022 (JP)
(74) Representative: Müller - Hoffmann & Partner
(86) International application number: PCT/JP2010/064444
(87) International publication number: WO 2011/024882

(57) **Abstract**

A liquid crystal display including a backlight and a filter, the backlight including a light-emitting device having a light-emitting element emitting blue light, and a green phosphor and a red phosphor absorbing a part of primary light emitted from the light-emitting element and emitting first secondary light and second secondary light, respectively, the green phosphor being a β-type SiAlON phosphor containing Eu and Al dissolved in a crystal of a nitride or an oxynitride having a β-type Si₃N₄ crystal structure, and the filter including filters for colors of red (R), green (G), blue (B) and yellow (Y), respectively, arranged in a plane for subpixels provided in each pixel of the liquid crystal display, which attains excellent color reproducibility (NTSC ratio) and high luminance, can be provided.

## Description

### TECHNICAL FIELD

The present invention relates to a liquid crystal display (LCD) using a light-emitting device including a light-emitting element emitting primary light and a wavelength conversion portion absorbing the primary light and emitting secondary light as a backlight.

### BACKGROUND ART

A light-emitting device including combination of a semiconductor light-emitting element and a phosphor has attracted attention as the next-generation light-emitting device expected to achieve low power consumption, small size, high luminance, and color reproduction of a broader range, and research and development of such light-emitting device has actively been conducted.

Light in a range from ultraviolet to blue having a long wavelength, that is, a wavelength from 380 to 480 nm, is normally employed as primary light emitted from a light-emitting element. There have also been proposed wavelength conversion portions using various types of phosphors suitable for this application. In addition, development of a backlight for small-sized, medium-sized as well as large-sized LCDs has recently become increasingly competitive. While various methods have been proposed in this field, a method satisfying both brightness and color reproducibility (NTSC ratio) remains to be developed.

At present, a light-emitting device including combination of a light-emitting element emitting blue light (peak wavelength: around 450 nm) and a cerium (III)-activated (Y, Gd)₃(Al, Ga)₅O₁₂ phosphor or a europium (II)-activated (Sr, Ba)₂SiO₄ phosphor, that is excited by the blue light and emits yellow light, has mainly been used as a light-emitting device exhibiting white emission.

An LCD using such light-emitting device as a backlight, however, attains color reproducibility (NTSC ratio) of around 70%. In recent years, higher color reproducibility has been demanded for various types of LCDs.

Furthermore, it has recently been attempted to increase brightness of these types of light-emitting devices by increasing not only conversion efficiency (brightness) but also input energy. If input energy is increased, heat needs to be efficiently dissipated from the entire light-emitting device including the wavelength conversion portion. While development of structure, material and the like of the entire light-emitting device has been advanced for this purpose, temperature rise in the light-emitting element and the wavelength conversion portion during operation is currently unavoidable.

However, particularly in the cerium (III)-activated (Y, Gd)₃(Al, Ga)₅O₁₂ phosphor, if its luminance (brightness) at 25°C is assumed to be 100%, the luminance at 100°C decreases to around 85%. Luminance of the europium (II)-activated (Sr, Ba)₂SiO₄ phosphor similarly decreases, which presents a technical problem of not being able to set input energy to high level. Therefore, it has urgently been demanded to improve temperature characteristics of a phosphor used in these types of light-emitting devices.

In regard to such technical problems, it is known that a light-emitting device attaining excellent color reproducibility (NTSC ratio) and temperature characteristics is obtained by using a green phosphor including a europium (II)-activated oxynitride which is β-type SiAlON substantially expressed as EuₑSi_{f}AlgOₕNᵢ.

The green phosphor including a europium (II)-activated oxynitride which is β-type SiAION described above has an emission peak wavelength in a range from around 530 to around 540 nm, and if the phosphor has a shorter wavelength (namely, in a range from 515 to 525 nm), its color reproducibility (NTSC ratio) tends to be improved. Under the circumstances, it has urgently been demanded to improve the color reproducibility (NTSC ratio) of a backlight for small-sized, medium-sized as well as large-sized LCDs.

Japanese Patent Laying-Open No. 2003-121838 (Patent Literature 1) is a known publication paying attention to color reproducibility (NTSC ratio) of an LCD. Patent Literature 1 states that a backlight light source has a spectral peak in a range from 505 to 535 nm, that an activator of a green phosphor used for the light source contains one of europium, tungsten, tin, antimony and manganese, and further that MgGa₂O₄:Mn Zn₂SiO₄:Mn is used as the phosphor emitting green light in the examples. If a light-emitting element has a peak wavelength in a range from 430 to 480 nm, however, a phosphor containing one of europium, tungsten, tin, antimony and manganese is not entirely applied. That is, MgGa₂O₄:Mn, Zn₂SiO₄:Mn described in the examples has significantly low luminous efficiency with excitation light in the range from 430 to 480 nm, and is not suitable for the application of the present invention.

Japanese Patent Laying-Open No. 2004-287323 (Patent Literature 2) states that a backlight may be an RGB-LED including an LED chip emitting red light, an LED chip emitting green light and an LED chip emitting blue light in one package, a three-wavelength fluorescent tube, combination of a ultraviolet LED and RGB phosphors, an organic EL light source and the like. Patent Literature 2, however, does not specifically disclose RG phosphors using blue light as an excitation source.

Japanese Patent Laying-Open No. 2005-255895 (Patent Literature 3) describes β-type SiAlON belonging to a hexagonal system and having an emission peak wavelength in a range from 525 to 546 nm. Patent Literature 3, however, does not disclose color reproducibility (NTSC ratio).

WO 2007/066733 (Patent Literature 4), Japanese Patent Laying-Open No. 2008-303331 (Patent Literature 5) and Japanese Patent Laying-Open No. 2009-010315 5 (Patent Literature 6) describe methods of controlling an emission spectrum by a crystal composition of β-type SiAlON, thereby improving color reproducibility (NTSC ratio) of a liquid crystal display, however, do not specifically disclose luminance of the display.

WO 2007/105631 (Patent Literature 7) describes SiAlON which is (M, R) AlSiON belonging to an orthorhombic system and having an emission peak wavelength in a range from 511 to 524 nm.

Toshiba Review, Vol. 64, No. 4, pp 60-63 (2009) (Non-Patent Literature 1) describes SiAION made of Sr₃Si₁₃Al₃O₂N₂₁ having an emission peak wavelength around 520 nm, and states that a general color rendering index (Ra) is from 82 to 88 if this phosphor is combined with a silicate-based red phosphor. This literature, however, does not describe color reproducibility (NTSC ratio).

A normal LCD uses a CCFL (Cold Cathode Fluorescent Lamp) as a backlight, and causes light therefrom to pass through each pixel of liquid crystal. Each pixel includes three subpixels through which the three primary colors RGB (red, green and blue) of light are transmitted, and each subpixel has a filter mounted thereon that corresponds to one of RGB (red, green and blue). Accordingly, color reproducibility (NTSC ratio) of the LCD is determined by combination of spectral characteristics of a light source and transmission spectral characteristics of a filter. There are examples where light including RGB and other colors is used as a filter for the purpose of improving color reproducibility, or improving luminance. For example, Japanese National Patent Publication No. 2004-529396 (Patent Literature 8) and Japanese Patent Laying-Open No. 2006-162706 (Patent Literature 9) report examples where at least four primary colors, e.g., RGB, Y (yellow) and C (cyan) are used as a filter.

### CITATION LIST

### PATENT LITERATURE

- PTL 1:: Japanese Patent Laying-Open No. 2003-121838 8
- PTL 2:: Japanese Patent Laying-Open No. 2004-287323
- PTL 3:: Japanese Patent Laying-Open No. 2005-255895
- PTL 4:: WO 2007/066733
- PTL 5:: Japanese Patent Laying-Open No. 2008-303331
- PTL 6:: Japanese Patent Laying-Open No. 2009-010315
- PTL 7:: WO 2007/105631 1
- PTL 8:: Japanese National Patent Publication No. 2004-529396
- PTL 9:: Japanese Patent Laying-Open No. 2006-162706

### NON-PATENT LITERATURE

- NPL 1:: Toshiba Review, Vol. 64, No. 4, pp 60-63 (2009)

### SUMMARY OF INVENTION

### TECHNICAL PROBLEM

The present invention was made in order to solve the problems described above, and an object of the present invention is to provide a liquid crystal display attaining excellent color reproducibility (NTSC ratio) and high luminance.

### SOLUTION TO PROBLEM

The present invention provides a liquid crystal display including a backlight and a filter, the backlight including a light-emitting device having a light-emitting element emitting blue light, and a green phosphor and a red phosphor absorbing a part of primary light emitted from the light-emitting element and emitting first secondary light and second secondary light, respectively, the green phosphor being a β-type SiAlON phosphor containing Eu and Al dissolved in a crystal of a nitride or an oxynitride having a β-type Si₃N₄ crystal structure, and the filter including filters for colors of red (R), green (G), blue (B) and yellow (Y), respectively, arranged in a plane for subpixels provided in each pixel of the liquid crystal display (such liquid crystal display of the present invention is hereinafter referred to as "first liquid crystal display").

In the first liquid crystal display of the present invention, oxygen concentration in a crystal of the green phosphor is preferably 0.1% by mass or more and 0.6% by mass or less.

In the first liquid crystal display of the present invention, Al concentration in a crystal of the green phosphor is preferably 0.13% by mass or more and 0.8% by mass or less.

In the first liquid crystal display of the present invention, Eu concentration in a crystal of the green phosphor is preferably 0.5% by mass or more and 4% by mass or less.

In the first liquid crystal display of the present invention, an emission peak wavelength of the green phosphor is preferably in a range from 520 to 537 nm.

The present invention also provides a liquid crystal display including a backlight and a filter, the backlight including a light-emitting device having a light-emitting element emitting blue light, and a green phosphor and a red phosphor absorbing a part of primary light emitted from the light-emitting element and emitting first secondary light and second secondary light, respectively, the green phosphor being a europium (II)-activated oxynitride phosphor expressed as General Formula (1)

(M1₁₋ₓEuₓ)ₐSi_{b}AlO_{c}N_{d} (1)

(in General Formula (1), M1 represents at least one alkaline earth metal element selected from Ca, Sr and Ba, and relations of 0.001 ≤ x ≤ 0.3, 0.9 ≤ a ≤ 1.5, 4.0 ≤ b ≤ 6.0, 0.4 ≤ c ≤ 1.0, and 6.0 ≤ d ≤ 11.0 are satisfied), and the filter including filters for colors of red (R), green (G), blue (B) and yellow (Y), respectively, arranged in a plane for subpixels provided in each pixel of the liquid crystal display (such liquid crystal display of the present invention is hereinafter referred to as "second liquid crystal display").

In the second liquid crystal display of the present invention, M1 in the General Formula (1) is preferably Sr.

In the second liquid crystal display of the present invention, an emission peak wavelength of the green phosphor is preferably in a range from 510 to 530 nm.

In the first and second liquid crystal displays of the present invention, the red phosphor is preferably a europium (II)-activated nitride phosphor expressed as General Formula (2)

(M2₁-yEuy)M3SiN₃ (2)

(in General Formula (2), M2 represents at least one alkaline earth metal element selected from Mg, Ca, Sr and Ba, M3 represents at least one trivalent metal element selected from Al, Ga, In, Sc, Y, La, Gd and Lu, and relation of 0.001 ≤ y ≤ 0.10 is satisfied).

M3 in the General Formula (2) is preferably at least one element selected from Al, Ga and In.

The present invention also provides a liquid crystal display including a backlight and a filter, the backlight including a light-emitting device having a light-emitting element emitting blue light, and a green phosphor and a red phosphor absorbing a part of primary light emitted from the light-emitting element and emitting first secondary light and second secondary light, respectively, an emission peak wavelength of the green phosphor being in a range from 510 to 537 nm, and the filter including filters for colors of red (R), green (G), blue (B) and yellow (Y), respectively, arranged in a plane for subpixels provided in each pixel of the liquid crystal display (such liquid crystal display of the present invention is hereinafter referred to as "third liquid crystal display").

In the third liquid crystal display of the present invention, an emission peak wavelength of the red phosphor is preferably in a range from 630 to 680 nm.

In the first and third liquid crystal displays of the present invention, a full width at half maximum of an emission spectrum of the green phosphor is preferably in a range from 40 to 55 nm.

In the third liquid crystal display of the present invention, one of the filters for green preferably has a transmittance peak wavelength in a wavelength range from 490 to 530 nm.

In the first, second and third liquid crystal displays of the present invention (hereinafter collectively referred to as "liquid crystal display of the present invention" when not distinguished from one another), the light-emitting element is preferably a gallium nitride (GaN)-based semiconductor emitting primary light having a peak in a range from 430 to 480 nm.

In the third liquid crystal display of the present invention, the green phosphor is preferably a β-type SiAlON phosphor containing Eu and Al dissolved in a crystal of a nitride or an oxynitride having a β-type Si₃N₄ crystal structure, or a europium (II)-activated oxynitride phosphor expressed as General Formula (1)

(M1₁₋ₓEuₓ)ₐSi_{b}AlO_{c}N_{d} (1)

(in General Formula (1), M1 represents at least one alkaline earth metal element selected from Ca, Sr and Ba, and relations of 0.001 ≤ x ≤ 0.3, 0.9 ≤ a ≤ 1.5, 4.0 ≤ b ≤ 6.0, 0.4 ≤ c ≤ 1.0, and 6.0 ≤ d ≤ 11.0 are satisfied).

In the third liquid crystal display of the present invention, the red phosphor is preferably a europium (II)-activated nitride phosphor expressed as General Formula (2)

(M2_{1-y}Eu_{y})M3SiN₃ (2)

(in General Formula (2), M2 represents at least one alkaline earth metal element selected from Mg, Ca, Sr and Ba, M3 represents at least one trivalent metal element selected from Al, Ga, In, Sc, Y, La, Gd and Lu, and relation of 0.001 ≤ y ≤ 0.10 is satisfied).

In the third liquid crystal display of the present invention, the liquid crystal display is preferably accommodated in a case together with a circuit for converting an RGB signal to an RGBY signal.

In the third liquid crystal display of the present invention, the liquid crystal display preferably has a refresh rate of 120 Hz or more, and is preferably driven by local dimming of changing brightness of the light-emitting device responsible for each area of a liquid crystal screen in response to the refresh rate.

### ADVANTAGEOUS EFFECTS OF INVENTION

According to the present invention, a liquid crystal display capable of obtaining a colorful image with high color reproducibility (NTSC ratio) can be provided. In addition, according to the liquid crystal display of the present invention, a brighter displayed image than could be conventionally achieved can be obtained owing to matching between the transmission characteristics of the subpixels of the four colors RGBY of the phosphors and the emission spectrum of the light-emitting device.

### BRIEF DESCRIPTION OF DRAWINGS

Fig. 1 is a perspective view schematically showing a substantial part of a liquid crystal display 1 in a preferred example of the present invention.
Fig. 2 is a cross-sectional view schematically showing a light-emitting device 11 suitably used as a backlight in liquid crystal display 1 of the present invention.
Fig. 3 is a graph showing an emission spectrum of the light-emitting device obtained in Example 1, with the axis of ordinate representing intensity (arbitrary unit), and the axis of abscissa representing wavelength (nm).
Fig. 4 is a graph showing transmission spectra of red (R), green (G), blue (B) and yellow (Y) filters of subpixels used in Example 1, with the axis of ordinate representing transmittance, and the axis of abscissa representing wavelength (nm).
Fig. 5 is a graph showing color reproduction gamuts of liquid crystal displays fabricated in Example 1 and Comparative Example 1, respectively.
Fig. 6 schematically shows a substantial part of a liquid crystal display 50 in another preferred example of the present invention.
Fig. 7 is a graph showing emission spectral characteristics of a light-emitting device used in Comparative Example 1, with the axis of ordinate representing intensity (arbitrary unit), and the axis of abscissa representing wavelength (nm).
Fig. 8 is a graph showing an emission spectrum of a light-emitting device obtained in Example 2, with the axis of ordinate representing intensity (arbitrary unit), and the axis of abscissa representing wavelength (nm).
Fig. 9 is a graph showing color reproduction gamuts of liquid crystal displays fabricated in Example 2 and Comparative Example 1, respectively.
Fig. 10 is an enlarged view of emission spectral distribution of the light-emitting device used in Example 2.
Fig. 11 is a configuration diagram of a liquid crystal television 80 incorporating a light-emitting device similar to that used in Example 1 except that the device is of a top emission type rather than of a side emission type as a backlight light source, and including an LCD having subpixels of red (R), green (G), blue (B) and yellow (Y), and circuits for driving the LCD.
Fig. 12 is a graph showing an emission spectrum of light-emitting device 11 obtained in Example 4, with the axis of ordinate representing intensity (arbitrary unit), and the axis of abscissa representing wavelength (nm).
Fig. 13 is a graph showing an emission spectrum of a light-emitting device using a β-type SiAlON phosphor as a green phosphor, in which a wavelength conversion portion is fabricated with adjustment to have luminous chromaticity substantially identical to that in Example 4, with the axis of ordinate representing intensity (arbitrary unit), and the axis of abscissa representing wavelength (nm).
Fig. 14 is a chromaticity diagram showing an example of color reproduction gamuts of the liquid crystal displays of the present invention.
Fig. 15 schematically shows transmission spectral characteristics of red (R), green (G), blue (B) and yellow (Y) filters used in Example 9.
Fig. 16 is a chromaticity diagram showing a color reproduction gamut 70 of a liquid crystal display fabricated in Example 9, and a color reproduction gamut 60 of a liquid crystal display fabricated in Example 4.

### DESCRIPTION OF EMBODIMENTS

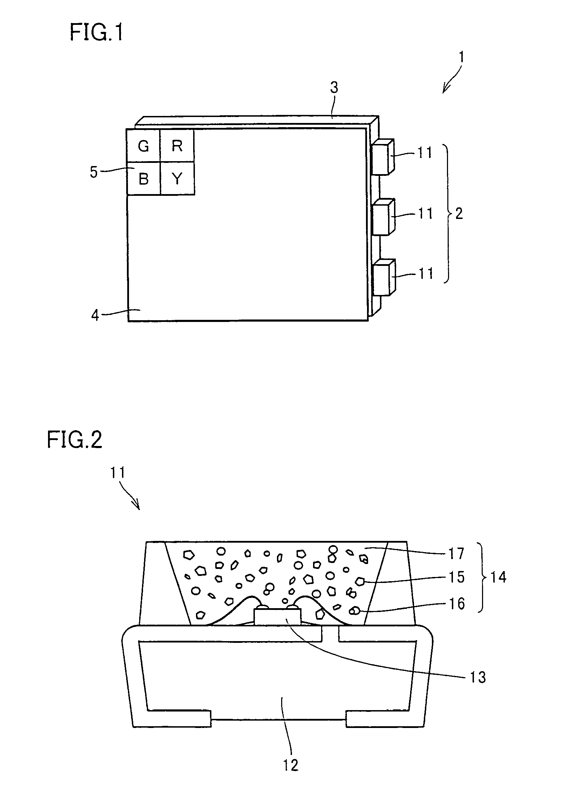

Fig. 1 is a perspective view schematically showing a substantial part of a liquid crystal display 1 in a preferred example of the present invention, and Fig. 2 is a cross-sectional view schematically showing a light-emitting device 11 suitably used as a backlight in liquid crystal display 1 of the present invention. Liquid crystal display 1 of the present invention basically includes a backlight 2 and a filter, and backlight 2 includes light-emitting device 11 having a light-emitting element emitting blue light, and a green phosphor and a red phosphor absorbing a part of primary light emitted from the light-emitting element and emitting first secondary light and second secondary light, respectively.

Liquid crystal display 1 of the present invention also includes a filter in which filters for colors of red (R), green (G), blue (B) and yellow (Y), respectively, are arranged in a plane for subpixels provided in each pixel of the liquid crystal display. As described above, Fig. 1 schematically shows the substantial part of liquid crystal display 1 (edge-lighting LCD) of the present invention (the inside of a liquid crystal cell, a polarizing plate and LCD element members normally used such as an optical sheet attached to a light guide plate are not shown), where light emitted from backlight 2 is introduced into a light guide plate 3, and light emitted upward from light guide plate 3 passes through each pixel 5 of a liquid crystal cell 4. One pixel 5 includes four subpixels of red (R), green (G), blue (B) and yellow (Y), and each subpixel is individually driven. While Fig. 1 shows an example where four subpixels are arranged from side to side and up and down to form one pixel, another arrangement where four subpixels are arranged in parallel in one pixel or the like may of course be employed.

Light-emitting device 11 suitably used as backlight 2 in first liquid crystal display 1 of the present invention includes a light-emitting element 13 mounted on a package 12, as shown in Fig. 2, for example. As light-emitting element 13 used in light-emitting device 11, a light-emitting element emitting blue light is used, and a gallium nitride (GaN)-based semiconductor emitting primary light having a peak in a range from 430 to 480 nm (more suitably a peak in a range from 440 to 470 nm) is particularly preferred, although not limited as such. This is because if the peak of the primary light from light-emitting element 13 is less than 430 nm, human visibility is lowered and luminance thus tends to be low, and if the peak exceeds 480 nm, a blue color reproduction gamut tends to be narrow. Light-emitting device 11 of the present invention includes a wavelength conversion portion 14 containing a green phosphor 15 5 and a red phosphor 16 dispersed in a medium 17.

### <First Liquid Crystal Display>

In the first liquid crystal display of the present invention, a β-type SiAlON phosphor containing Eu and Al dissolved in a crystal of a nitride or an oxynitride having a β-type Si₃N₄ crystal structure is used as green phosphor 15. Since β-type SiAlON has a very small spectral line width among common rare earth-activated phosphors, in the liquid crystal display employing the light-emitting device using β-type SiAlON, a spectrum and a backlight filter are well matched, thereby achieving a wide color reproduction gamut, as will be described later.

Oxygen concentration in the green phosphor which is a β-type SiAlON phosphor as described above is preferably 0.1 % by mass or more and 0.6% by mass or less, and is more preferably 0.2% by mass or more and 0.4% by mass or less. If the oxygen concentration is less than 0.2% by mass, growth of phosphor particles is insufficient and luminous intensity tends to be low. In addition, by setting the oxygen concentration to 0.4% by mass or less, uniformity of a coordination structure in the vicinity of Eu (II) which is a light-emitting ion can be improved to reduce a spectral half-width. It is noted that the oxygen concentration in the green phosphor is a value obtained by oxygen concentration measurement with an infrared absorption method, for example.

Al concentration in the green phosphor which is a β-type SiAlON phosphor as described above is preferably 0.13% by mass or more and 0.8% by mass or less, and is more preferably 0.2% by mass or more and 0.7% by mass or less. By setting the Al concentration to 0.2% by mass or more and 0.7% by mass or less, intensity of a peak around 527 nm among subpeaks can be maximum intensity. It is noted that the Al concentration in the green phosphor is a value measured with ICP emission spectrometry, for example.

Eu concentration in the green phosphor which is a β-type SiAlON phosphor as described above is preferably 0.5% by mass or more and 4% by mass or less, and is more preferably 0.5% by mass or more and 1% by mass or less. By setting the Eu concentration to 0.5% by mass or more and 1% by mass or less, a charge balance around Eu ions can be optimized. If the charge balance around the Eu ions is inappropriate, concentration of Eu (III) ions that do not contribute to emission increases, and concentration of Eu (II) ions that contribute to green emission decreases. It is noted that the Eu concentration in the green phosphor is a value measured with ICP emission spectrometry, for example.

A particle size of the green phosphor which is a β-type SiAlON phosphor as described above is not particularly limited, yet is preferably in a range from 5 to 25 µm, and is more preferably in a range from 8 to 20 µm when expressed in median diameter (50%D). This is because if the particle size of the green phosphor is less than 5 µm, crystal growth is insufficient and luminous efficiency thus tends to be low, and scattering and absorption losses due to Mie scattering tend to increase, and if the particle size of the green phosphor exceeds 25 µm, a grain boundary phase increases due to abnormal crystal growth and baking, and luminous efficiency tends to be low.

The above-described green phosphor used in the first liquid crystal display preferably has an emission peak wavelength in a range from 520 to 537 nm. If the emission peak wavelength of the green phosphor used in the first liquid crystal display is less than 520 nm, luminous intensity on the long wavelength is low, and thus luminous intensity of yellow is low and white luminance tends to be low. If the emission peak exceeds 537 nm, there is a lack of improvement in color impurity of green, and a spectrum of the red phosphor needs to be suppressed in order to achieve white balance, and red luminance thus tends to be low.

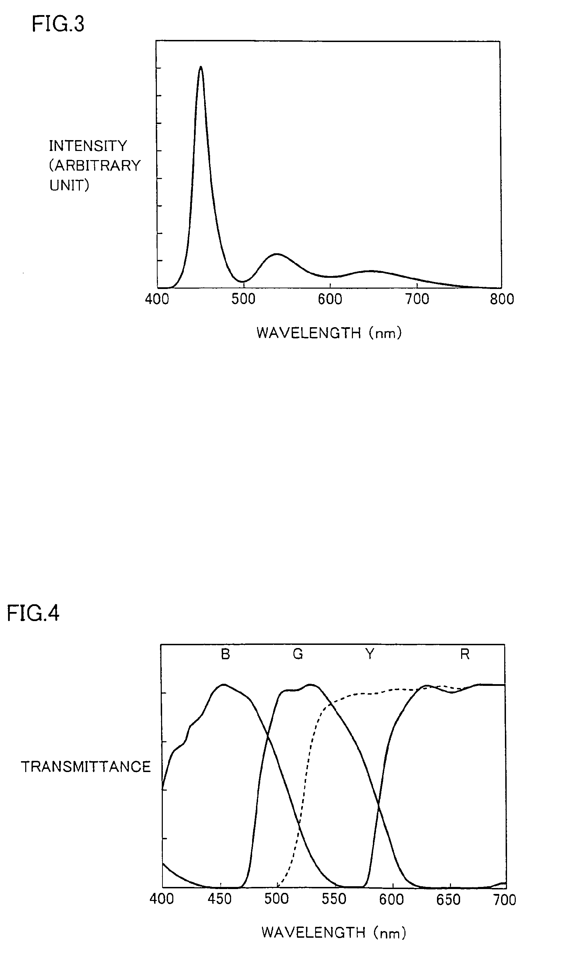

Fig. 3 is a graph showing an emission spectrum of light-emitting device 11 obtained in Example 1 to be described later, with the axis of ordinate representing intensity (arbitrary unit), and the axis of abscissa representing wavelength (nm). As such, in the present invention, light-emitting device 11 having spectral characteristics adjusted in accordance with the transmission characteristics of liquid crystal display 1 is employed by using a specific phosphor that emits light at high efficiency by the light in a range from 430 to 480 nm from the semiconductor light-emitting element, thereby realizing a liquid crystal display attaining excellent color reproducibility (NTSC ratio) and high luminance. It is noted that the NTSC ratio is a percentage relative to an area of a triangle obtained by connecting chromaticity coordinates of red (0.670, 0.330), green (0.210, 0.710) and blue (0.140, 0.080) defined by the NTSC (National Television System Committee) in a color reproduction gamut in an XYZ color system chromaticity diagram of the liquid crystal display.

Fig. 4 is a graph showing transmission spectra of red (R), green (G), blue (B) and yellow (Y) filters of subpixels used in Example 1 to be described later, with the axis of ordinate representing transmittance, and the axis of abscissa representing wavelength (nm). As can be seen from Fig. 4, a light-emitting device using a light-emitting element emitting blue light and phosphors has a relatively broad spectrum. Thus, if only three filters of red (R), green (G) and blue (B) are used to cover those wavelength regions, these filters need to have a wide transmission band, resulting in lower color purity and a narrower color reproduction gamut. For this reason, liquid crystal display 1 of the present invention uses a yellow (Y) filter, thereby improving luminance across the broad spectrum of the light-emitting device using the light-emitting element emitting blue light and the phosphors.

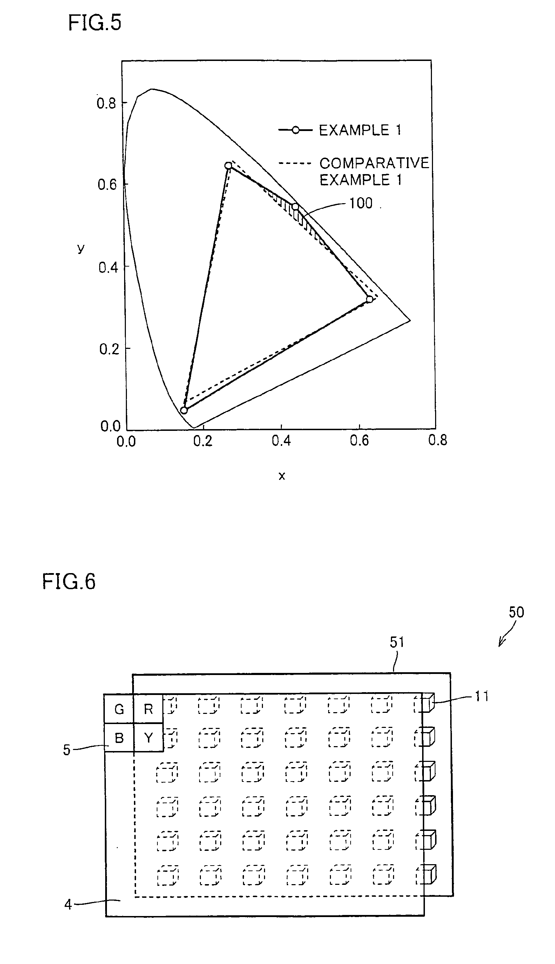

Fig. 5 is a graph showing color reproduction gamuts of the liquid crystal displays fabricated in Example 1 and Comparative Example 1 to be described later, respectively. As can be seen from Fig. 5, in the color reproduction gamut in Example 1, a yellow region important in a liquid crystal display could be successfully expanded by using the Y filter. In general, if transmittance of a yellow region is increased, peak values of a green phosphor and a red phosphor of a light-emitting device need to be lowered in order to achieve white balance. Thus, a green color reproduction gamut tends to be narrow. Nevertheless, if a β-type SiAION phosphor containing Eu and Al dissolved in a crystal of a nitride or an oxynitride having a β-type Si₃N₄ crystal structure is used as a green phosphor, a spectrum and the filter are well matched, and spectral separation between blue and green is particularly clear, thereby ensuring sufficient color reproducibility of a green region as compared to that in Comparative Example l. Since the light-emitting element emitting blue light relatively has high peak intensity, a blue color reproduction gamut is also widened. As a result, the NTSC ratio in Example 1 was improved from that in the comparative example, and in particular, the expansion of the yellow color reproduction gamut (gamut 100 in Fig. 5) having high human visibility led to improvement in brightness of a screen and improvement in white luminance. This may be because the combination of phosphors used in the present invention has moderate luminous intensity of a yellow region.

### <Second Liquid Crystal Display>

In second liquid crystal display 1 of the present invention, a europium (II)-activated oxynitride phosphor substantially expressed as General Formula (1) below is used as green phosphor 15.

(M1₁₋ₓEuₓ)ₐSi_{b}AlO_{c}N_{d} (1)

In General Formula (1), M 1 represents at least one alkaline earth metal element selected from Ca, Sr and Ba, and is preferably Sr. In General Formula (1), x indicating europium (Eu) concentration is a number that satisfies relation of 0.001 ≤ x ≤ 0.3. If x is less than 0.001, sufficient brightness is not obtained, and if x exceeds 0.3, brightness significantly decreases due to concentration quenching and the like. In terms of stability of characteristics and uniformity of matrix, x is preferably in a range of 0.005 ≤ x ≤ 0.1.

In General Formula (1), if a, b, c and d are in ranges of 0.9 ≤ a ≤ 1.5, 4.0 ≤ b ≤ 6.0, 0.4 ≤ c ≤ 1.0 and 6.0 ≤ d ≤ 11.0, respectively, the effect of an impurity phase is ignorable, and excellent emission characteristics (brightness) can be obtained.

Such green phosphor including a europium (II)-activated oxynitride used in the second liquid crystal display of the present invention is merely an example assuming that an index of Al in General Formula (1) above is 1, and may specifically include, but is not limited to, (Sr_{0.99}Eu_{0.01})₃Si₁₃Al₃O₂N₂₁, (Sr_{0.95}Eu_{0.05})₅Si₂₅Al₅O₄N₃₉, (Sr_{0.98}Eu_{0.02})₅Si₂₀Al₄O₃N₃₂, (Sr_{0.89}Ba_{0.01}Eu_{0.10})₄Si₂₂Al₄O₃N₃₄, (Sr_{0.989}Ca_{0.01}Eu_{0.001})₆Si₂₃Al₅O₄N₃₇, (Sr_{0.97}Eu_{0.03})₁₆Si₆₈Al₁₄O₁₁N₁₀₈, (Sr_{0.96}Ba_{0.02}Eu_{0.02})₉₀Si₃₁₅Al₇₀O₆₃N₅₀₈, (Sr_{0.995}Eu₀.₀₀₅)₃Si₁₆Al₃O₂N₂₅, (Sr₀.₈₇Ca_{0.03}Eu_{0.01})₆Si₂₆Al₅O₄N₄₁, (Sr_{0.99}Eu_{0.01})₅Si₂₁Al₅O₂N₃₅, (Sr_{0.95}Eu_{0.05})₅Si₂₁Al₅O₂N₃₅, (Sr₀.₉₉₅Eu_{0.005})₅Si₂₃Al₅O₃N₃₇, and (Sr_{0.97}Eu_{0.03})₁₉Si₉₀Al₂₀O₁₃N₁₉₂.

A particle size of green phosphor 15 used in second liquid crystal display 1 of the present invention is not particularly limited, yet is preferably in a range from 10 to 30 µm when expressed in median diameter (50%D). This is because if the particle size of green phosphor 15 used in second liquid crystal display 1 of the present invention is less than 10 pm, crystal growth is insufficient and brightness tends to be significantly low, and if the particle size exceeds 30 µm, there will be many abnormally grown particles, which is not practical.

Green phosphor 15 used in second liquid crystal display 1 of the present invention preferably has an emission peak wavelength in a range from 510 to 530 nm, and is more preferably in a range from 515 to 525 nm. This is because if the emission peak wavelength of green phosphor 15 used in second liquid crystal display 1 of the present invention is less than 510 nm, brightness is significantly lowered due to the effect of visibility, and a green color reproduction gamut tends to be narrow since a gap with a peak of blue becomes smaller, and if the emission peak wavelength exceeds 530 nm, a chromaticity point of a peak of green becomes closer to yellow, causing the green color reproduction gamut to be narrow, thus lacking in improvement in color impurity of green, and a spectrum of the red phosphor needs to be suppressed in order to achieve white balance to obtain excellent backlight characteristics.

### <Third Liquid Crystal Display>

In third liquid crystal display 1 of the present invention, a green phosphor having an emission peak wavelength in a range from 510 to 537 nm is used as green phosphor 15. If the emission peak wavelength of green phosphor 15 in the third liquid crystal display is less than 510 nm, brightness is significantly lowered due to the effect of visibility, and a green color reproduction gamut tends to be narrow since a gap with a peak of blue becomes smaller, and if the emission peak wavelength exceeds 537 nm, there is a lack of improvement in color impurity of green, and a spectrum of the red phosphor needs to be suppressed in order to achieve white balance, causing lowering of red luminance.

The green phosphor in the third liquid crystal display of the present invention is not particularly limited so long as the emission peak wavelength is in a range from 510 to 537 nm, yet is preferably the β-type SiAlON phosphor containing Eu and Al dissolved in a crystal of a nitride or an oxynitride having a β-type Si₃N₄ crystal structure which was used in the first liquid crystal display described above, or the europium (II)-activated oxynitride phosphor substantially expressed as above General Formula (1) which was used in the second liquid crystal display described above.

Red phosphor 16 used in liquid crystal display 1 of the present invention is not particularly limited, yet is preferably a europium (II)-activated phosphor substantially expressed as General Formula (2) below.

(M2_{1-y}Eu_{y})M3SiN₃ (2)

In General Formula (2), M2 represents at least one alkaline earth metal element selected from Mg, Ca, Sr and Ba, and is preferably Ca or Sr. In General Formula (2), M3 represents at least one trivalent metal element selected from Al, Ga, In, Sc, Y, La, Gd and Lu, and is preferably at least one selected from Ag, Ga and In so that red emission at further high efficiency can be achieved.

In General Formula (2), y indicating europium (Eu) concentration is a number that satisfies relation of 0.001 ≤ y ≤ 0.10. If y is less than 0.001, sufficient brightness is not obtained, and if y exceeds 0.10, brightness significantly decreases due to concentration quenching and the like. In terms of stability of characteristics and uniformity of matrix, y is preferably in a range of 0.005 ≤ y ≤ 0.05.

Such red phosphor 16 may specifically include, but is of course not limited to, (Ca_{0.99}Eu_{0.01})AlSiN₃, (Ca_{0.97}Mg_{0.02}Eu_{0.01})(Al_{0.99}Ga_{0.01})SiN₃, (Ca_{0.98}Eu_{0.02})AiSiN₃, (Ca_{0.58}Sr_{0.40}Eu_{0.02})(Al_{0.98}In_{0.02})SiN₃, (Ca_{0.999}Eu_{0.001})AlSiN₃, (Ca_{0.895}Sr_{0.100}Eu_{0.005})AlSiN₃, (Ca_{0.79}Sr_{0.2}oEu_{0.01})AlSiN₃, (Ca_{0.98}Eu_{0.02})(Al_{0.95}Ga_{0.05})SiN₃, (Ca_{0.02}Sr_{0.79}Eu_{0.01}))AlSiN₃, (Ca_{0.98}Sr_{0.01}Eu_{0.01})AlSiN₃, and (Ca_{0.99}Eu_{0.01})(Al_{0.99}Ga_{0.01})SiN₃.

Red phosphor 16 used in liquid crystal display 1 of the present invention preferably has an emission peak wavelength in a range from 630 to 680 nm, and more preferably in a range from 640 to 660 nm. This is because if the emission peak wavelength of red phosphor 16 is less than 630 nm, a red color reproduction gamut tends to be narrow, and if the emission peak wavelength exceeds 680 nm, human visibility is lowered and luminance thus tends to be low.

A particle size of red phosphor 16 is not particularly limited, either, yet is preferably in a range from 6 to 20 µm when expressed in median diameter (50%D). This is because if the particle size of red phosphor 16 is less than 6 µm, crystal growth is insufficient and brightness tends to be significantly low, and if the particle size of red phosphor 16 exceeds 20 µm, there will be many abnormally grown particles, which is not practical.

In light-emitting device 11 used as backlight 2 in liquid crystal display 1 of the present invention, wavelength conversion portion 14 is fabricated by dispersing green phosphor 15 and red phosphor 16 into medium 17. Medium 17 is not particularly limited, and may be a translucent resin material such as epoxy resin, silicone resin, or urea resin.

The green phosphor used in liquid crystal display 1 of the present invention preferably has a full width at half maximum of the emission spectrum in a range from 40 to 55 nm, and more preferably in a range from 40 to 52 nm. This is because if the full width at half maximum of the emission spectrum of the green phosphor is less than 40 nm, luminous intensity on the long wavelength is low, and thus luminous intensity of yellow is low and white luminance tends to be low, and if the full width at half maximum exceeds 55 nm, a chromaticity point of a peak of green becomes closer to a white point, and thus the green color reproduction gamut tends to be narrow.

Fig. 6 schematically shows a substantial part of a liquid crystal display 50 in another preferred example of the present invention. While Fig. 1 shows an example of the edge-lighting liquid crystal display using the light guide plate, backside-illuminated liquid crystal display 50 without a light guide plate may be employed with light-emitting devices 11 arranged on a backside as shown in Fig. 6. In Fig. 6, parts having structures similar to those in the example illustrated in Fig. 1 are designated with the same reference signs, and the descriptions thereof will not be repeated. In Fig. 6, light-emitting device 11 is mounted on a mounting substrate 51. A backside-illuminated liquid crystal display provides great energy saving since brightness of a backlight can be modulated on a pixel-by-pixel basis, and can have a higher contrast ratio between light and dark.

In the liquid crystal display of the present invention, a filter for green is illustrated as suitably having a transmittance peak wavelength in a wavelength range from 490 to 530 nm.

The liquid crystal display of the present invention can be accommodated in a case together with a circuit for converting an RGB signal to an RGBY signal. The liquid crystal display preferably has a refresh rate of 120 Hz or more, and is preferably driven by local dimming of changing brightness of the light-emitting device responsible for each area of a liquid crystal screen in response to the refresh rate.

While the present invention will now be described in more detail with reference to examples, the present invention is not limited to these examples.

### <Example 1 >

First, light-emitting device 11 having a structure similar to that shown in Fig. 2 including the light-emitting element mounted on the package and the wavelength conversion portion containing the green phosphor and the red phosphor dispersed in the medium was fabricated. In light-emitting device 11, a gallium nitride (GaN)-based semiconductor having a peak wavelength at 450 nm of blue was used as the light-emitting element, a Eu-activated β-type SiAlON phosphor having a peak wavelength around 540 nm (Eu concentration in crystal: 0.6% by mass, Al concentration in crystal: 2% by mass, oxygen concentration in crystal: 1.1% by mass) was used as the green phosphor, and (Ca_{0.99}Eu_{0.01})AlSiN₃ was used as the red phosphor. A mixture of the green phosphor and the red phosphor in a ratio of 1 :0.25 was dispersed into silicone resin which is the medium, to fabricate the wavelength conversion portion. Fig. 3 is a graph showing an emission spectrum of light-emitting device 11 thus obtained, with the axis of ordinate representing intensity (arbitrary unit), and the axis of abscissa representing wavelength (nm). As shown in Fig. 3, light-emitting device 11 obtained in Example 1 has spectral characteristics adjusted in accordance with transmission characteristics of a liquid crystal display to be fabricated. The emission spectral characteristics are illustrated as characteristics normalized by peak intensity of blue light, in the examples in the following description as well.

Liquid crystal display 1 as shown in Fig. 1 was fabricated by using obtained light-emitting device 11 as backlight 2. Four subpixels of red (R), green (G), blue (B) and yellow (Y) were configured to be individually driven, and arranged from side to side and up and down to form one pixel. Fig. 4 is a graph showing transmission spectra of red (R), green (G), blue (B) and yellow (Y) filters of subpixels used in Example l, with the axis of ordinate representing transmittance, and the axis of abscissa representing wavelength (nm). It can be seen that by using the yellow (Y) filter, the luminance can be improved across the broad spectrum of light-emitting device 11 using the light-emitting element emitting blue light and the phosphors, as described above.

### <Comparative Example 1>

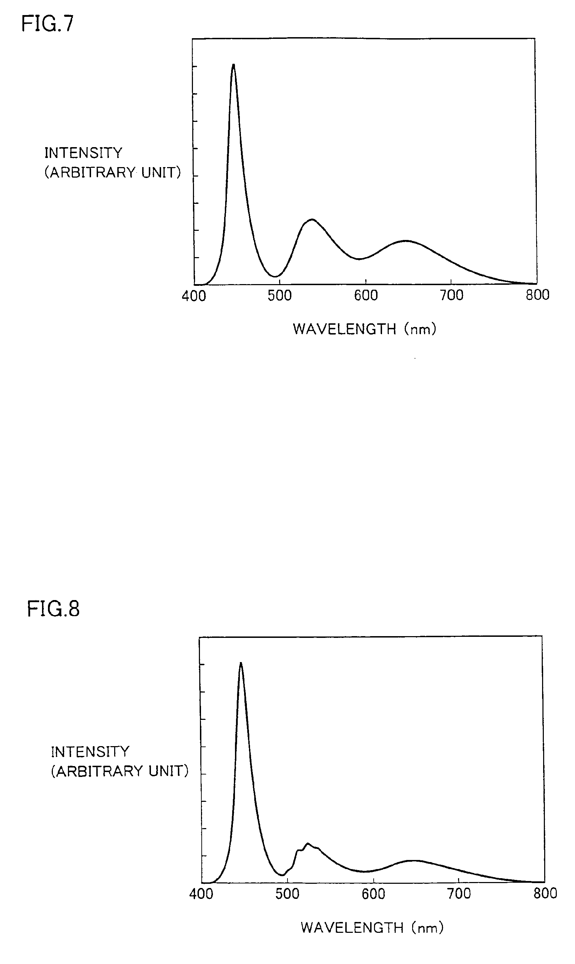

A liquid crystal display was fabricated as in Example 1, except for using only three conventional filters of red (R), green (G) and blue (B), and setting a ratio of the green phosphor and the red phosphor in the light-emitting device to 1:0.35 in accordance with filter characteristics. Fig. 7 is a graph showing emission spectral characteristics of the light-emitting device used in Comparative Example 1, with the axis of ordinate representing intensity (arbitrary unit), and the axis of abscissa representing wavelength (nm).

Fig. 5 is a graph showing color reproduction gamuts of the liquid crystal displays fabricated in Example 1 and Comparative Example 1 described above, respectively. As can be seen from Fig. 5, in the color reproduction gamut in Example 1, a yellow region important in an LCD could be successfully expanded by using the Y filter. Since β-type SiAlON was used in Example l, the spectrum and the filter were well matched, and spectral separation between blue and green was particularly clear, thereby ensuring sufficient color reproducibility of a green region as compared to that in Comparative Example 1. Since the light-emitting element emitting blue light relatively had high peak intensity, a blue color reproduction gamut was also widened. As a result, the NTSC ratio in Example 1 was 85.8%, which was an improvement from 83.4% in Comparative Example 1. In particular, the expansion of the yellow color reproduction gamut (gamut indicated with a sign 100 in the figure) having high human visibility led to improvement in brightness of a screen and improvement in white luminance by about 10%. While the Eu, Al and oxygen concentrations in a crystal of the green phosphor were set to 0.6% by mass, 2% by mass and 1.1% by mass in this Example, respectively, equivalent emission characteristics were obtained when the Eu concentration was 0.5% by mass or more and 1.0% by mass or less, the Al concentration was 1.5% by mass or more and 2.5% by mass or less, and the oxygen concentration was 0.8% by mass or more and 2.0% by mass or less.

### <Example 2>

Light-emitting device 11 was fabricated as in Example 1, except for using a Eu-activated β-type SiAlON phosphor having a peak wavelength in a range from 520 to 530 nm (Eu concentration in crystal: 0.5% by mass, Al concentration in crystal: 0.6% by mass, oxygen concentration in crystal: 0.3% by mass) as the green phosphor, using (Ca_{0.99}Eu_{0.01})AlSiN₃ as the red phosphor, and mixing the green phosphor and the red phosphor in a ratio of 1:0.33. Fig. 8 is a graph showing an emission spectrum of the light-emitting device obtained in Example 2, with the axis of ordinate representing intensity (arbitrary unit), and the axis of abscissa representing wavelength (nm). As shown in Fig. 8, the light-emitting device obtained in Example 2 has spectral characteristics adjusted in accordance with transmission characteristics of a liquid crystal display to be described below. The liquid crystal display was fabricated as in Example 1 by using the light-emitting device thus obtained as a backlight.

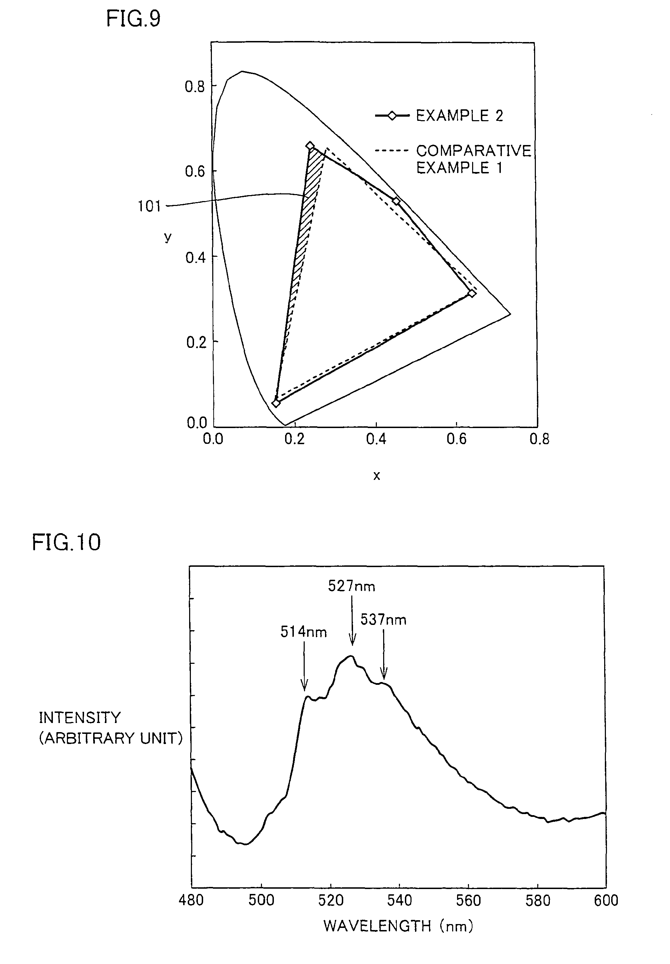

Fig. 9 is a graph showing color reproduction gamuts of the liquid crystal displays fabricated in Example 2 and Comparative Example 1 described above, respectively. In Example 2, it can be seen again that a yellow region important in a liquid crystal display could be successfully expanded by using the Y filter, as in Example 1. Moreover, in Example 2, a green color reproduction gamut could be significantly widened by using β-type SiAlON having a peak wavelength in a range from 520 to 530 nm as the green phosphor in the light-emitting device. As described above, since a β-type SiAlON phosphor has a very small spectral line width among common rare earth-activated phosphors, a spectrum and a backlight filter are well matched, and a wide color reproduction gamut is achieved. By employing the composition having a further shorter peak wavelength and a further smaller spectral line width as in Example 2, the green color reproduction gamut (gamut indicated with a sign 101 in the figure) could be further expanded. As a result, color between blue and green regions, which was conventionally difficult to reproduce in a liquid crystal display, could be reproduced. Usually, if a peak wavelength of a green phosphor is made shorter, separation from a peak of blue is deteriorated and blue reproducibility tends to be low. In Example 2, however, since the spectrum is narrowed with the shortening of the wavelength of the green phosphor, the spectral separation between blue and green is not reduced, thereby ensuring a blue reproduction gamut as well. As a result, the NTSC ratio in Example 2 was 92.5%, which was a significant improvement from 83.4% in Comparative Example 1. The white luminance was also improved by about 5% as compared to Comparative Example 1. Further, in Example 2, display luminance of a red region was improved by about 10% as compared to Example l, owing to higher luminous intensity of the red phosphor. This is because a mixture ratio of the red phosphor can be increased in order to achieve white balance with the shortening of the wavelength of the green phosphor. For the same reason, color reproducibility of a red region was also improved as compared to Comparative Example 1.

If the Eu-activated β-type SiAION phosphor had oxygen concentration in crystal of 0.1 % by mass or more and 0.6% by mass or less, Al concentration in crystal of 0.13% by mass or more and 0.8% by mass or less, and Eu concentration in crystal of 0.5% by mass or more and 4% by mass or less, the emission peak wavelength was shortened to a range from 520 to 530 nm, high luminous efficiency was exhibited, and the spectral line width was reduced. If the oxygen concentration in a crystal of the Eu-activated β-type SiAlON phosphor was more than 0.6% by mass, the full width at half maximum of the emission spectrum had a value in a range from around 53 to around 55 nm, whereas if the oxygen concentration was 0.6% by mass or less, the value was in a range from 45 to 52nm, which shows that the width becomes smaller with reduction in oxygen concentration. Thus, when subpixels of four colors of red (R), green (G), blue (B) and yellow (Y) are used in the liquid crystal display, color impurity of green is increased to significantly improve the color reproduction gamut, as will be described later.

This is owing to the emission spectrum specific to the Eu-activated β-type SiAION phosphor having the above composition. As was shown in Fig. 8, the green emission spectrum of the Eu-activated β-type SiAlON phosphor having the above composition has several emission peaks superimposed on one another when looked in detail. Fig. 10 is an enlarged view of this portion. The emission peaks include three subpeaks around 514 nm, 527 nm and 537 nm. The Eu-activated β-type SiAION phosphor has the emission spectrum formed by the superimposition of these plurality of emission peaks, and when having the specific composition as described above, the entire emission spectral half-width is reduced, making the subpeaks clear. Accordingly, the half width is smaller than in Example l, the emission peak wavelength is shortened, and emission with high color purity of green is obtained. The emission peak wavelength at this time has the peak around 527 nm in the above peaks as a main peak. While a peak actually appears in a range from 520 to 530 nm depending on the difference in composition, and by the effect of other peaks due to thermal energy, the best backlight characteristics are obtained in this case.

While the emission spectrum as described above is obtained if the Eu-activated β-type SiAlON phosphor has oxygen concentration in crystal of 0.1 % by mass or more and 0.6% by mass or less, Al concentration in crystal of 0.13% by mass or more and 0.8% by mass or less, and Eu concentration in crystal of 0.5% by mass or more and 4% by mass or less, it is more desirable that the oxygen concentration be 0.2% by mass or more and 0.4% by mass or less, the Al concentration be 0.2% by mass or more and 0.7% by mass or less, and the Eu concentration be 0.5% by mass or more and 1% by mass or less. If the oxygen concentration is less than 0.2% by mass, growth of phosphor particles is insufficient and luminous intensity is low. In addition, by setting the oxygen concentration to 0.4% by mass or less, uniformity of a coordination structure in the vicinity of Eu (II) which is a light-emitting ion can be improved to reduce a spectral half-width. By setting the Al concentration to 0.2% by mass or more and 0.7% by mass or less, intensity of a peak around 527 nm among subpeaks can be maximum intensity. By setting the Eu concentration to 0.5% by mass or more and 1% by mass or less, a charge balance around Eu ions can be optimized. If the charge balance around the Eu ions is inappropriate, concentration of Eu (III) ions that do not contribute to emission increases, and concentration of Eu (II) ions that contribute to green emission decreases.

While the phosphors suitable for the present invention are illustrated in above Examples, phosphors other than those illustrated may be employed, so long as they have wavelengths well matched with red (R), green (G), blue (B) and yellow (Y) filters.

### <Example 3>

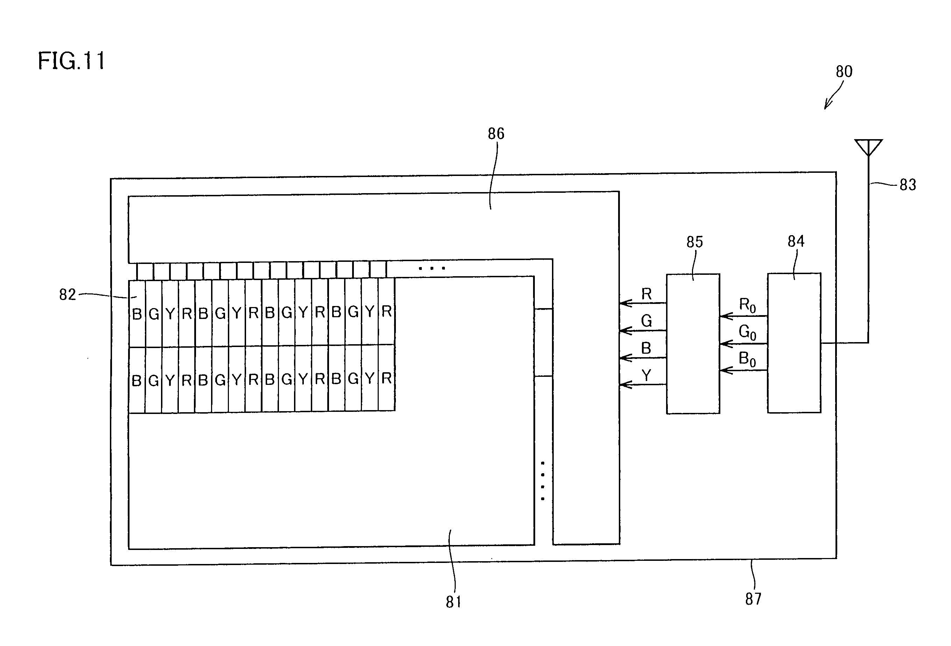

Fig. 11 is a configuration diagram of a liquid crystal television 80 incorporating the light-emitting device similar to that used in Example 1 except that the device is of a top emission type rather than of a side emission type as a backlight light source, and including a liquid crystal display having subpixels of red (R), green (G), blue (B) and yellow (Y), and circuits for driving the liquid crystal display. Here, the light-emitting devices similar to that used in Example 1 except that the devices are of a top emission type rather than of a side emission type were arranged in a matrix on a backside of a liquid crystal display panel, to fabricate a liquid crystal television having a screen size of 46 inches using a liquid crystal display 81 which is a liquid crystal panel of an area active type (local dimming type) for emitting LED light from the backside. In liquid crystal display 81, each pixel 82 includes subpixels of red (R), green (G), blue (B) and yellow (Y).

Liquid crystal television 80 in the example illustrated in Fig. 11 includes a circuit 84 for generating signals of R₀ (red), Go (green) and B₀ (blue) based on a broadcast signal obtained from an exterior antenna 83, a circuit 85 for generating signals of RGBY (red, green, blue and yellow) from the signals afro (red), Go (green) and B₀ (blue), a liquid crystal drive circuit 86 for generating an LCD drive signal based on a video signal, LCD 81, and a case 87 for supporting LCD 81 and the circuits. In circuit 86, a Y (yellow) signal is operated from a G (green) signal and an R (red) signal in principle, and an addition ratio thereof is adjusted depending on the level of each signal in order to optimize the entire display color (for example, the yellow signal becomes zero when only complete green is displayed).

Human subjective evaluation of sample images displayed on this television was made. In particular, favorable evaluation results were obtained on sample images ` including large amounts of green and yellow components such as fruits and skin colors, owing to improvement in color reproducibility. For smooth display of moving images, a refresh rate of the liquid crystal screen was set to 120 Hz or 240 Hz. In order to display an image with such high refresh rate by area active driving, a drive signal for a light-emitting device responsible for each area is set depending on luminance information required for each area which is generated with each refresh. The drive signal was a PWM (Pulse Width Modulation) signal having a frequency of 600 Hz higher than that of the refresh rate.

A response speed of a phosphor used in the light-emitting device does not necessarily need to respond to the PWM signal, yet needs to respond to the refresh rate. Since the β-type SiAlON green phosphor had a 1/e fluorescence life of about 1 µsec, and the (Ca_{0.99}Eu_{0.01})AlSiN₃ red phosphor similarly had a high-speed 1/e fluorescence life of about 1 psec, the response speed could respond to the area active driving even with the refresh rate of 240 Hz.

While the liquid crystal television is illustrated in Example 3, a wide color reproduction gamut is obtained for a liquid crystal monitor for a computer as well. In addition, since power consumption is relative low with the high NTSC ratio as a whole, the device is suitable for a liquid crystal monitor or a liquid crystal television of an AC power supply cordless type.

### <Example 4>

Light-emitting device 11 as shown in Fig. 2 including light-emitting element 13 mounted on package 12, and wavelength conversion portion 14 containing green phosphor 15 and red phosphor 16 dispersed in medium 17 was fabricated. In light-emitting device 11, a gallium nitride (GaN)-based semiconductor having a peak wavelength at 450 nm of blue was used as light-emitting element 13, (Sr_{0.99}Eu_{0.01})₃Si₁₃Al₃O₂N₂₁ having a peak wavelength around 520 nm was used as green phosphor 15, and (Ca_{0.99}Eu_{0.01})AlSiN₃ was used as red phosphor 16. A mixture of green phosphor 15 and red phosphor 16 in a ratio of 1:0.35 was dispersed into silicone resin which is medium 17, to fabricate wavelength conversion portion 14.

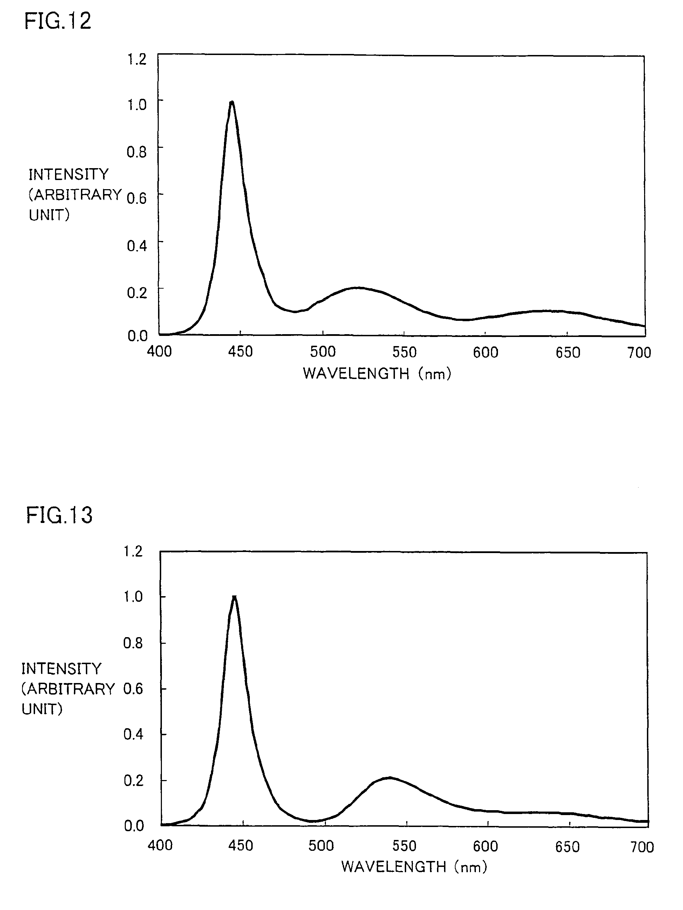

The characteristics of light-emitting device 11 incorporating wavelength conversion portion 14, and liquid crystal display 1 using light-emitting device 11 as a backlight were evaluated. The results are shown in Table 1. Fig. 12 shows emission spectral characteristics of the light-emitting device in Example 4.

### <Comparative Example 2>

A light-emitting device was fabricated as in Example 4, except for using (Sr_{0.48}Ba_{0.47}Eu_{0.05})₂SiO₄ (peak wavelength: around 520 nm) as the green phosphor, and using (Ca_{0.99}Eu_{0.01})AlSiN₃ as the red phosphor. The characteristics of a liquid crystal display using this light-emitting device as a backlight were evaluated. The results are shown in Table 1.

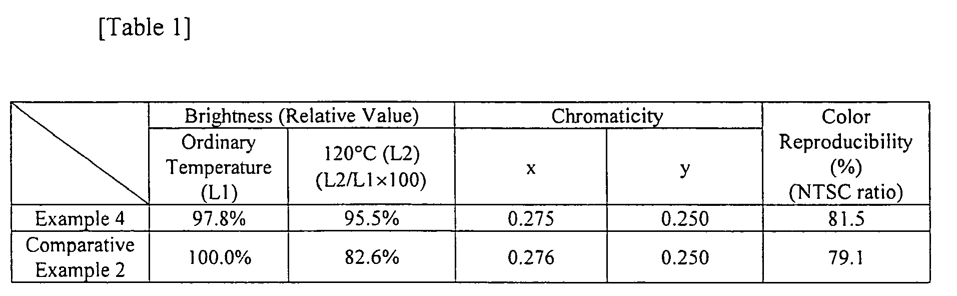

As can be seen from Table 1, the light-emitting device in Example 4 achieves significantly improved temperature characteristics as compared to Comparative Example 2, and the liquid crystal display using the light-emitting device in Example 4 as a backlight achieves further improved color reproducibility (NTSC ratio) as compared to Comparative Example 2. As such, the obtained light-emitting device has characteristics suitable as a backlight of various types of (particularly large-sized) liquid crystal displays.

### <Example 5>

Light-emitting device 11 was fabricated as in Example 4, except for using a gallium nitride (GaN)-based semiconductor having a peak wavelength at 440 nm of blue as the light-emitting element, using (Sr_{0.95}Eu_{0.05})₅Si₂₁Al₅O₂N₃₅ (peak wavelength: around 525 nm) as the green phosphor, and using (Ca_{0.98}Eu_{0.02})AlSiN₃ as the red phosphor. The characteristics of the light-emitting device thus fabricated and a liquid crystal display using this light-emitting device as a backlight were evaluated. The results are shown in Table 2.

### <Comparative Example 3>

A light-emitting device was fabricated as in Example 5, except for using (Sr_{0.53}Ba_{0.42}Eu_{0.05})₂SiO₄ (peak wavelength: around 525 nm) as the green phosphor. The characteristics of the light-emitting device thus fabricated and a liquid crystal display using this light-emitting device as a backlight were evaluated. The results are shown in Table 2.

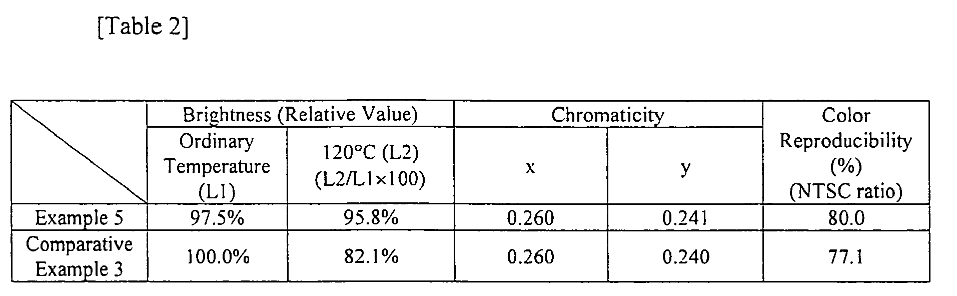

As can be seen from Table 2, the light-emitting device in Example 5 achieves significantly improved temperature characteristics, and the liquid crystal display using this light-emitting device achieves further improved color reproducibility (NTSC ratio), as compared to Comparative Example 3. As such, the obtained light-emitting device has characteristics suitable as a backlight of various types of (particularly large-sized) liquid crystal displays.

### <Examples 6 to 8 and Comparative Examples 4 to 6>

Light-emitting devices were fabricated as in Example 4, except for using light-emitting elements, green phosphors and red phosphors having peak wavelengths as shown in Table 3 below, respectively. The various characteristics of these fabricated light-emitting devices and liquid crystal displays using these light-emitting devices were evaluated, the results of which are shown in Table 4.

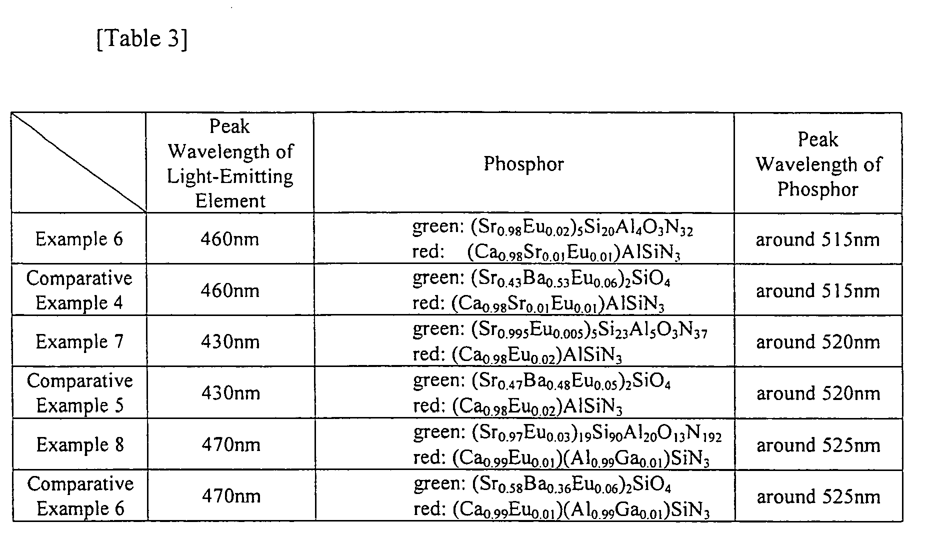

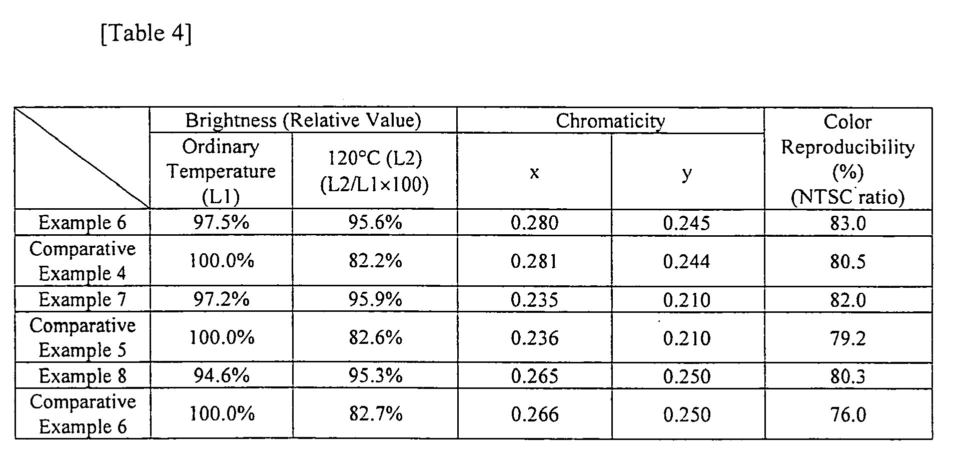

As can be seen from Tables 3 and 4, the liquid crystal displays using the light-emitting devices fabricated in Examples 6 to 8 achieve further improved color reproducibility (NTSC ratio), and significantly improved temperature characteristics, as compared to the liquid crystal displays using the light-emitting devices fabricated in Comparative Examples 4 to 6. As such, the obtained light-emitting devices have characteristics suitable as a backlight of various types of (particularly large-sized) liquid crystal displays.

With regard to improvement in temperature characteristics of a phosphor used in this type of light-emitting device, it is known that a liquid crystal display having excellent color reproducibility (NTSC ratio) and temperature characteristics is obtained by using a green light-emitting phosphor including a europium (II)-activated oxynitride which is β-type SiAlON. On the other hand, if the europium (II)-activated oxynitride phosphor substantially expressed as above General Formula (1) is used, emission of a shorter wavelength, namely, emission in a range from 515 to 525 nm becomes possible, and a liquid crystal display attaining high color reproducibility (NTSC ratio) can be provided by using such phosphor.

Fig. 13 is a graph showing an emission spectrum of a light-emitting device using a β-type SiAlON phosphor as a green phosphor, in which the wavelength conversion portion was fabricated with adjustment to have luminous chromaticity substantially identical to that in Example 4, with the axis of ordinate representing intensity (arbitrary unit), and the axis of abscissa representing wavelength (nm). In Fig. 13, a green region has an emission peak in a range from around 530 to around 540 nm, with the emission of the green region becoming closer to the long wavelength as compared to that in Fig. 12, while emission of a red region is suppressed to achieve a balance, so that the luminous chromaticity identical to that in Example 4 is obtained.

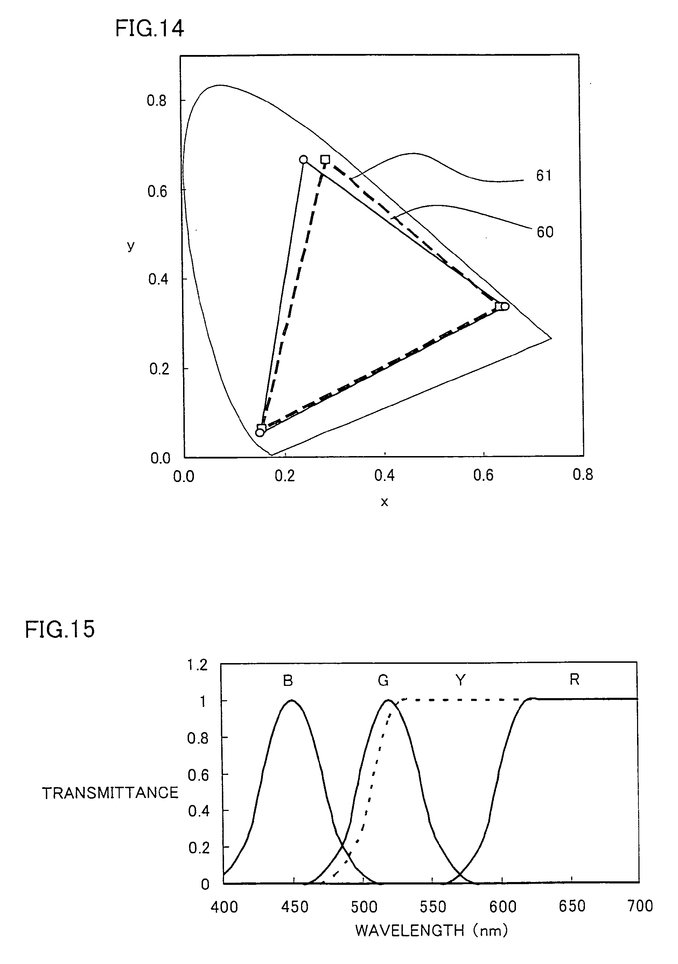

Fig. 14 is a chromaticity diagram showing an example of color reproduction gamuts of the liquid crystal displays of the present invention. In Fig. 14, a reference sign 61 represents a color reproduction gamut of a liquid crystal display incorporating a light-emitting device using a europium-activated oxynitride β-type SAlON green phosphor as a backlight light source, and a reference sign 60 represents a color reproduction gamut of a liquid crystal display incorporating the light-emitting device fabricated in Example 4 as a backlight light source. It can be seen that color reproduction gamut 60 of the liquid crystal display fabricated in Example 4 attains improved reproducibility of a green region in particular, as compared to color reproduction gamut 61 of the light-emitting device using the β-type SiAlON phosphor.

### <Example 9>

The liquid crystal display having the structure shown in Fig. 1 was fabricated as in Example 4, except for using subpixels of four colors of red (R), green (G), blue (B) and yellow (Y). Light emitted from the light-emitting device using the phosphors in Example 4 is introduced into the light guide plate, and light emitted upward from the light guide plate passes through each pixel of the liquid crystal cell. One pixel includes four subpixels of red (R), green (G), blue (B) and yellow (Y), and each subpixel is individually driven. While four subpixels are arranged from side to side and up and down to form one pixel, another arrangement where four subpixels are arranged in parallel in one pixel or the like may be employed.

Fig. 15 schematically shows transmission spectral characteristics of red (R), green (G), blue (B) and yellow (Y) filters used in Example 9. A light-emitting device using an LED emitting blue light and phosphors has a relatively broad spectrum. Thus, if only three filters of red (R), green (G) and blue (B) are used to cover those wavelength regions, these filters need to have a wide transmission band, resulting in lower color purity and a narrower color reproduction gamut. By using a yellow (Y) filter, luminance can be improved across the broad spectrum of the light-emitting device using the LED emitting blue light and the phosphors.

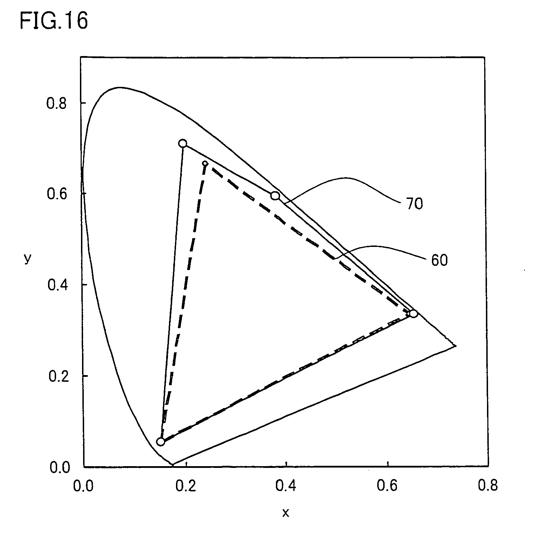

Fig. 16 is a chromaticity diagram showing a color reproduction gamut 70 of the liquid crystal display fabricated in Example 9, and color reproduction gamut 60 of the liquid crystal display fabricated in Example 4. It can be seen from Fig. 16 that the color reproduction gamut of the liquid crystal display could be expanded by not only simply adding the subpixel of yellow, but also by shifting a central transmission wavelength of the subpixel of green which is a color more adjacent to yellow away from yellow toward the short wavelength. That is, in this Example, by using a yellow (Y) filter, a green (G) filter having a short wavelength and a narrow band could be used. In this Example, the central wavelength of the green (G) filter was set to 520 nm. A suitable central wavelength of the green (G) filter for expanding the color reproduction gamut is 530 nm or less, and is preferably 520 nm or less. In order to reduce overlapping with blue, the wavelength is preferably 490 nm or more, and is preferably 500 nm or more.

A peak wavelength of the red phosphor suitable for combination with red (R), green (G), blue (B) and yellow (Y) filters is preferably 590 nm or more, and is more preferably 610 nm or more, considering that the red filter is used in the liquid crystal display and that a spectrum of the phosphor is deformed by being pulled toward the long wavelength. An appropriate upper limit of the wavelength is 680 nm or less since visibility is low on the long wavelength, and is more preferably 660 nm or less. A peak wavelength of the green phosphor is preferably in a range from 510 nm or more to 530 nm or less, and is more preferably in a range from 515 nm or more to 525 nm or less, considering that the color reproduction gamut can be widened by making the wavelength of a green filter shorter.

While the edge-lighting liquid crystal display using the light guide plate is illustrated in this Example, a backside-illuminated liquid crystal display without a light guide plate may be employed with light-emitting devices arranged on a backside of the liquid crystal display. A backside-illuminated liquid crystal display provides great energy saving since brightness of a backlight can be modulated on a pixel-by-pixel basis, and can have a higher contrast ratio between light and dark.

While the phosphors used in Example 4 are used in Example 9, phosphors used in Examples other than Example 4 may be employed, or the phosphors in Comparative Examples or other phosphors may be employed, so long as they have wavelengths well matched with red (R), green (G), blue (B) and yellow (Y) filters.

### <Example 10>

Liquid crystal television 80 incorporating the light-emitting device similar to that used in Example 4 except that the device is of a top emission type rather than of a side emission type as a backlight light source, and including the liquid crystal display having subpixels of red (R), green (G), blue (B) and yellow (Y), and the circuits for driving the liquid crystal display configured in a manner similar to that shown in Fig. 11 was fabricated. The descriptions of the parts similar to those illustrated in Example 3 will not be repeated.

Human subjective evaluation of sample images displayed on this television was fabricated. In particular, favorable evaluation results were obtained on sample images including large amounts of green and yellow components such as fruits and skin colors, owing to improvement in color reproducibility.

For smooth display of moving images, a refresh rate of the liquid crystal screen was set to 120 Hz or 240 Hz. In order to display an image with such high refresh rate by area active driving, a drive signal for a light-emitting device responsible for each area is set depending on luminance information required for each area which is generated with each refresh. The drive signal was a PWM (Pulse Width Modulation) signal having a frequency of 600 Hz higher than that of the refresh rate.

A response speed of a phosphor used in the light-emitting device does not necessarily need to respond to the PWM signal, yet needs to respond to the refresh rate. Since the (Sr_{0.99}Eu_{0.01})₃Si₁₃Al₃O₂N₂₁ green phosphor (peak wavelength: around 520 nm) had a 1/e fluorescence life of about 1 µsec, and the (Ca_{0.99}Eu_{0.01})AlSiN₃ red phosphor similarly had a high-speed 1/e fluorescence life of about 1 µsec, the response speed could respond to the area active driving even with the refresh rate of 240 Hz.

While the liquid crystal display uses the subpixels of red (R), green (G), blue (B) and yellow (Y), a similar effect is obtained when another subpixel, e.g., one or a plurality of subpixels of white (W), cyan (C) and magenta (M) are added. If another color is added, a signal of that color also needs to be generated from the R₀, G₀ and B₀ signals.

While the liquid crystal television is illustrated in Example 10, a wide color reproduction gamut is obtained for a liquid crystal monitor for a computer as well. In addition, since power consumption is relative low with the high NTSC ratio as a whole, the device is suitable for a liquid crystal monitor or a liquid crystal television of an AC power supply cordless type.

In the evaluation of the light-emitting devices in above Examples, the brightness was measured by lighting the light-emitting element with a forward current (IF) of 20 mA, and measuring light output (photocurrent) from the light-emitting device. The chromaticity (x, y) was measured by determining a value of light emitted from the light-emitting device with MCPD-2000 available from Otsuka Electronics Co., Ltd. The color reproducibility (NTSC ratio) was measured by incorporating the fabricated light-emitting device as a backlight light source of the liquid crystal display, and measuring a value with Bm5 available from TOPCON CORPORATION.

### INDUSTRIAL APPLICABILITY

The LCD according to the present invention can obtain a colorful image with high color reproducibility (NTSC ratio) and high luminance. Particularly, in the present invention, high color reproducibility (NTSC ratio) and a clear displayed image can be obtained by combining the specific phosphors with the liquid crystal display having subpixels of four colors of RGBY, and the present invention is thus applicable to small-sized, medium-sized and large-sized liquid crystal displays.

### REFERENCE SIGNS LIST

1, 50, 81 liquid crystal display; 2 backlight; 3 light guide plate; 4 liquid crystal cell; 11 light-emitting device; 12 package; 13 light-emitting element; 14 wavelength conversion portion; 15 green phosphor; 16 red phosphor; 17 medium; 5, 82 pixel; 51 mounting substrate; 80 liquid crystal television; 83 exterior antenna; 84 R₀G₀B₀ signal generation circuit; 85 RGBY signal generation circuit; 86 liquid crystal drive circuit; 87 case.

## Claims

1. A liquid crystal display including a backlight and a filter,
said backlight including a light-emitting device having a light-emitting element emitting blue light, and a green phosphor and a red phosphor absorbing a part of primary light emitted from said light-emitting element and emitting first secondary light and second secondary light, respectively,
said green phosphor being a β-type SiAlON phosphor containing Eu and Al dissolved in a crystal of a nitride or an oxynitride having a β-type Si₃N₄ crystal structure, and
said filter including filters for colors of red (R), green (G), blue (B) and yellow (Y), respectively, arranged in a plane for subpixels provided in each pixel of said liquid crystal display.

2. The liquid crystal display according to claim 1, wherein
oxygen concentration in a crystal of said green phosphor is 0.1 % by mass or more and 0.6% by mass or less.

3. The liquid crystal display according to claim 1, wherein
Al concentration in a crystal of said green phosphor is 0.13% by mass or more and 0.8% by mass or less.

4. The liquid crystal display according to claim 1, wherein
Eu concentration in a crystal of said green phosphor is 0.5% by mass or more and 4% by mass or less.

5. The liquid crystal display according to claim 1, wherein
an emission peak wavelength of said green phosphor is in a range from 520 to 537 nm.

6. A liquid crystal display including a backlight and a filter,
said backlight including a light-emitting device having a light-emitting element emitting blue light, and a green phosphor and a red phosphor absorbing a part of primary light emitted from said light-emitting element and emitting first secondary light and second secondary light, respectively,
said green phosphor being a europium (II)-activated oxynitride phosphor expressed as General Formula (1)
(Ml₁₋ₓEuₓ)ₐSi_{b}AlO_{c}N_{d} (1)
(in General Formula (1), M1 represents at least one alkaline earth metal element selected from Ca, Sr and Ba, and relations of 0.001 ≤ x ≤ 0.3, 0.9 ≤ a ≤ 1.5, 4.0 ≤ b ≤ 6.0, 0.4 ≤ c ≤ 1.0, and 6.0 ≤ d ≤ 11.0 are satisfied), and
said filter including filters for colors of red (R), green (G), blue (B) and yellow (Y), respectively, arranged in a plane for subpixels provided in each pixel of said liquid crystal display.

7. The light-emitting device according to claim 6, wherein
M1 in said General Formula (1) is Sr.

8. The light-emitting device according to claim 6, wherein
an emission peak wavelength of said green phosphor is in a range from 510 to 530 nm.

9. The light-emitting device according to claim 1 or 6, wherein
said red phosphor is a europium (II)-activated nitride phosphor expressed as General Formula (2)
(M2₁-yEuy)M3siN₃ (2)
(in General Formula (2), M2 represents at least one alkaline earth metal element selected from Mg, Ca, Sr and Ba, M3 represents at least one trivalent metal element selected from Al, Ga, In, Sc, Y, La, Gd and Lu, and relation of 0.001 ≤ y ≤ 0.10 is satisfied).

10. The light-emitting device according to claim 9, wherein
M3 in said General Formula (2) is at least one element selected from Al, Ga and In.

11. A liquid crystal display including a backlight and a filter,
said backlight including a light-emitting device having a light-emitting element emitting blue light, and a green phosphor and a red phosphor absorbing a part of primary light emitted from said light-emitting element and emitting first secondary light and second secondary light, respectively,
an emission peak wavelength of said green phosphor being in a range from 510 to 537 nm, and
said filter including filters for colors of red (R), green (G), blue (B) and yellow (Y), respectively, arranged in a plane for subpixels provided in each pixel of said liquid crystal display.

12. The light-emitting device according to claim 11, wherein
an emission peak wavelength of said red phosphor is in a range from 630 to 680 nm.

13. The liquid crystal display according to claim 1 or 11, wherein
a full width at half maximum of an emission spectrum of said green phosphor is in a range from 40 to 55 nm.

14. The liquid crystal display according to claim 11, wherein
one of said filters for green has a transmittance peak wavelength in a wavelength range from 490 to 530 nm.

15. The light-emitting device according to claim 1, 6 or 1 l, wherein
said light-emitting element is a gallium nitride (GaN)-based semiconductor emitting primary light having a peak in a range from 430 to 480 nm.

16. The light-emitting device according to claim 11, wherein
said green phosphor is a β-type SiAlON phosphor containing Eu and Al dissolved in a crystal of a nitride or an oxynitride having a β-type Si₃N₄ crystal structure.

17. The light-emitting device according to claim 11, wherein
said green phosphor is a europium (II)-activated oxynitride phosphor expressed as General Formula (1)
(Ml₁₋ₓEuₓ)ₐSi_{b}AlO_{c}N_{d} (1)
(in General Formula (1), M1 represents at least one alkaline earth metal element selected from Ca, Sr and Ba, and relations of 0.001 ≤ x ≤ 0.3, 0.9 ≤ a ≤ 1.5, 4.0 ≤ b ≤ 6.0, 0.4 ≤ c ≤ 1.0, and 6.0 ≤ d ≤ 11.0 are satisfied).

18. The liquid crystal display according to claim 11, wherein
said red phosphor is a europium (II)-activated nitride phosphor expressed as General Formula (2)
(M2₁-yEuy)M3SiN₃ (2)
(in General Formula (2), M2 represents at least one alkaline earth metal element selected from Mg, Ca, Sr and Ba, M3 represents at least one trivalent metal element selected from Al, Ga, In, Sc, Y, La, Gd and Lu, and relation of 0.001 ≤ y ≤ 0.10 is satisfied).

19. The liquid crystal display according to claim 11, wherein
said liquid crystal display is accommodated in a case together with a circuit for converting an RGB signal to an RGBY signal.

20. The liquid crystal display according to claim 11, wherein
said liquid crystal display has a refresh rate of 120 Hz or more, and is driven by local dimming of changing brightness of said light-emitting device responsible for each area of a liquid crystal screen in response to said refresh rate.
